# FASCICULE DE BREVET EUROPEEN

(11) **EP 0 948 038 B1**
(45) Date de publication et mention de la délivrance du brevet: **24.01.2007**
(21) Numéro de dépôt: 99410025.3
(22) Date de dépôt: 30.03.1999
(51) Int. Cl.: H01L 21/329, H01L 29/866

(54) **Procédé de fabrication d'une diode à avalanche à seuil réglable**
Herstellungsverfahren für eine Avalanche-Diode mit steuerbarem Schwellwert
Method of fabricating an avalanche diode with controllable threshold

(30) Priorité: 31.03.1998 FR 9804207
(43) Date de publication de la demande: 06.10.1999
(73) Titulaire: STMicroelectronics S.A., 92120 Montrouge (FR)
(72) Inventeur: Claverie, Isabelle, 13850 Greasque (FR)
(74) Mandataire: de Beaumont, Michel

(56) Documents cités:
- EP-A- 0 359 679
- US-A- 4 416 708
- PATENT ABSTRACTS OF JAPAN vol. 008, no. 190 (E-263), 31 août 1984 & JP 59 079578 A (HITACHI SEISAKUSHO KK), 8 mai 1984
- PATENT ABSTRACTS OF JAPAN vol. 006, no. 218 (E-139), 2 novembre 1982 & JP 57 122579 A (MITSUBISHI DENKI KK), 30 juillet 1982

## Description

La présente invention concerne la fabrication de diodes à avalanche dans des circuits intégrés, par exemple des circuits intégrés de puissance.

Dans de tels circuits, on a souvent besoin de définir plusieurs seuils de déclenchement, par exemple pour réaliser divers dispositifs de protection contre des décharges électrostatiques, des inversions de batterie, et autres.

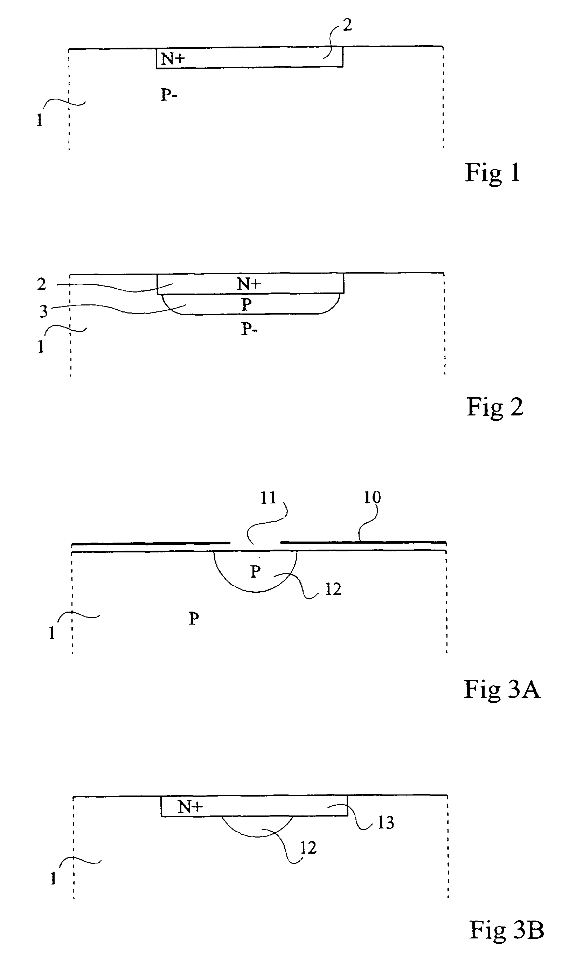

De façon générale, comme le représente la figure 1, une diode à avalanche est réalisée en formant dans un substrat 1 d'un premier type de conductivité, une région 2 du type de conductivité opposé. On notera que le terme substrat est utilisé ici pour désigner une région ou couche supérieure d'un composant semiconducteur, par exemple un circuit intégré. La région 2 est généralement fortement dopée et le seuil de claquage de la diode à avalanche est essentiellement déterminé par le niveau de dopage du substrat 1 (moins le substrat est dopé, plus la tension de claquage du dispositif est élevée).

La figure 2 représente un autre exemple de diode à avalanche couramment utilisé dans des circuits intégrés. Dans le substrat 1 du premier type de conductivité, est réalisée une région 3 diffusée (ou implantée-diffusée) du même premier type de conductivité. Une région 2 du type de conductivité opposé est formée de façon à déborder latéralement par rapport à la région 3 pour obtenir un claquage indépendant des effets de bord et de surface. En supposant que le substrat 1 de la figure 2 est le même que celui de la figure 1, la tension d'avalanche de la jonction 2-3, qui dépend du niveau de dopage de la région P, est nécessairement moins élevée que celle de la jonction 2-1 puisque la concentration de la région 3 à sa jonction avec la région 2 est nécessairement plus élevée que celle de la région 1.

Ainsi, de façon générale, dans tout procédé de fabrication d'un composant semiconducteur ou d'un circuit intégré, on peut utiliser les divers types de diffusion prévus pour la fabrication d'autres composants du circuit intégré pour former des diodes à avalanche. Toutefois, les seuils de claquage des diverses diodes sont déterminés sans possibilité de choix par le niveau de dopage des régions existantes et, dans de nombreuses filières simples de fabrication de circuits intégrés tels que des circuits intégrés de puissance, il n'existe que les deux possibilités illustrées en figures 1 et 2.

Ainsi, dans un dispositif existant, pour obtenir une diode à seuil d'avalanche spécifique, il faudrait prévoir une région diffusée 3 spécifique, c'est-à-dire à dose d'implantation spécifique ou à durée de recuit spécifique. Il est bien entendu inimaginable dans un circuit intégré de prévoir une zone à durée de recuit spécifique car le recuit réalisé pour cette zone réagirait sur les autres zones du circuit intégré. D'autre part, réaliser une implantation à dose spécifique augmenterait le nombre d'étapes de fabrication du circuit intégré, ce que l'on cherche toujours à éviter dans une filière existante. Une structure de diode selon la préambule de la revendication 1 est connue de JP-A-59-079 578 et de EP-A-359 679.

Ainsi, un objet de la présente invention est de prévoir un procédé de fabrication d'une diode à avalanche de seuil déterminé, distinct des seuils existant naturellement en utilisant les jonctions existantes dans une filière déterminée, ce seuil pouvant être choisi sans ajouter d'étape de traitement supplémentaire aux étapes existantes.

Pour atteindre ces objets, la présente invention prévoit un procédé de fabrication d'une diode à avalanche à seuil déterminé dans un substrat d'un premier type de conductivité à faible niveau de dopage, comprenant les étapes consistant à faire diffuser dans le substrat au moins une première région du premier type de conductivité ; faire diffuser dans le substrat une deuxième région du deuxième type de conductivité débordant par rapport à la première région. L'ouverture d'un masque de définition de la première région a une étendue latérale inférieure à la profondeur de diffusion de la première région dans le substrat, cette étendue latérale étant choisie d'autant plus faible que le seuil d'avalanche recherché est élevé.

Selon un mode de réalisation de la présente invention, chaque diffusion est précédée d'une implantation.

Selon un mode de réalisation de la présente invention, chaque première région comprend une pluralité de sous-régions disjointes et identiques.

La présente invention prévoit aussi un procédé de fabrication simultanée de plusieurs diodes à avalanche de seuils distincts et déterminés dans un substrat d'un premier type de conductivité à faible niveau de dopage comprenant les étapes consistant à faire diffuser dans le substrat des premières régions du premier type de conductivité ; faire diffuser dans le substrat des deuxièmes régions du deuxième type de conductivité dont chacune déborde par rapport à une première région. Les ouvertures des masques de définition de chacune des premières régions ont des étendues latérales distinctes, inférieures à la profondeur de diffusion des premières régions, l'étendue latérale étant d'autant plus faible que le seuil d'avalanche recherché est élevé.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1 et 2 représentent des diodes à avalanche selon l'art antérieur ;
les figures 3A et 3B illustrent des étapes de réalisation d'une diode à avalanche selon la présente invention ;
les figures 4A à 4C illustrent des étapes de réalisation d'une diode à avalanche selon la présente invention ; et
les figures 5A et 5B illustrent des étapes de réalisation d'une diode à avalanche selon la présente invention.

La figure 3A représente une première étape de fabrication d'une diode à avalanche selon la présente invention. La structure est formée dans un substrat 1 d'un premier type de conductivité qui sera considéré ci-après à titre d'exemple comme le type P. Sur ce substrat est formé un masque d'implantation 10 comportant une ouverture 11. Un dopant de type P est implanté dans ce substrat puis amené à diffuser pour former une région 12 de type P plus fortement dopée que le substrat. L'ouverture dans le masque 11 est choisie inférieure à la profondeur de diffusion de la région 12.

A une étape suivante, on implante et on fait diffuser une région 13 de type N fortement dopée en débordement par rapport à la région 12.

Etant donné que la dimension latérale de l'ouverture 11 dans le masque 10 est inférieure à la profondeur de diffusion de la région P, la diffusion des dopants à partir de la zone implantée est aussi importante latéralement que dans le sens de la profondeur. Ainsi, au niveau de la partie profonde de la région 12 et plus particulièrement au niveau de son interface avec la région 13, cette région se trouve plus faiblement dopée que dans le cas de la couche 3 de la figure 2 qui a une largeur nettement supérieure à sa profondeur. On comprendra que le dopage à l'interface est d'autant plus faible que l'ouverture 11 est plus petite. On dispose ainsi d'un moyen pour régler le niveau de dopage de la région 12 au niveau de sa jonction avec la région 13. On obtient ainsi une diode à avalanche entre les régions 13 et 12 de tension d'avalanche intermédiaire entre celles des diodes à avalanche des figures 1 et 3. De plus, cette diode à avalanche a un seuil réglable qui dépend de la dimension de l'ouverture 11 dans le masque 10. On pourra former simultanément dans le substrat 1 plusieurs diodes à avalanche les unes ayant le seuil correspondant à celui de la figure 1, les autres ayant le seuil correspondant à la structure de la figure 2, et d'autres encore, selon l'invention, ayant des seuils choisis intermédiaires entre ceux des structures des figures 1 et 2.

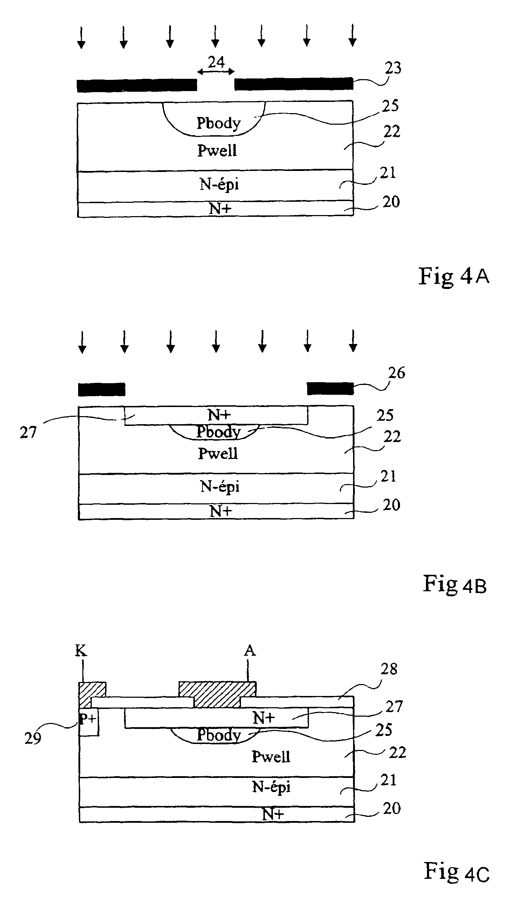

On va décrire plus en détail un mode de réalisation de la présente invention en relation avec les figures 4A à 4C dans le cadre d'une technologie de fabrication de transistors MOS de puissance associés à des circuits logiques, dans laquelle la structure est formée sur une tranche de silicium de type N fortement dopée 20 sur laquelle est formée une couche épitaxiée 21 de type N. Dans cette couche épitaxiée est formé un caisson 22 de type P qui, dans le cadre de la fabrication de transistors MOS de puissance associés à des circuits logiques, correspond à la diffusion dans laquelle sont formés les caissons des circuits logiques. C'est cette diffusion de caisson qui correspond au "substrat" 1 des figures 1 à 3. Dans ce caisson, à travers un masque 23 présentant une ouverture de dimension réduite 24 est implanté un dopant de type P tel que du bore, cette étape de dopage correspondant par exemple à la formation de caissons de transistors de type DMOS dans la partie de puissance du circuit. Après recuit, on obtient une région diffusée 25 analogue à la région 12 de la figure 3A. Alors, comme le représente la figure 4B, on procède à travers un masque 26 à la formation d'une couche de type N fortement dopée 27 qui correspond par exemple aux régions de source de transistors DMOS. Enfin, comme le représente la figure 4C, on dépose un oxyde d'isolement 28, on forme une région 29 de type P fortement dopée de reprise de contact sur la région 22, puis l'on forme des métallisations de cathode K et sur la région 29 et d'anode A sur la région 27.

Tandis que la jonction entre la région 27 et la région 22 aurait dans un procédé de fabrication particulier une tension de claquage de 20 volts et que la jonction entre la région N⁺ et une région 25 étendue aurait une tension de claquage de l'ordre de 7 volts, on peut obtenir, selon la valeur de l'ouverture 24 une diode de tension de claquage choisie entre ces deux valeurs.

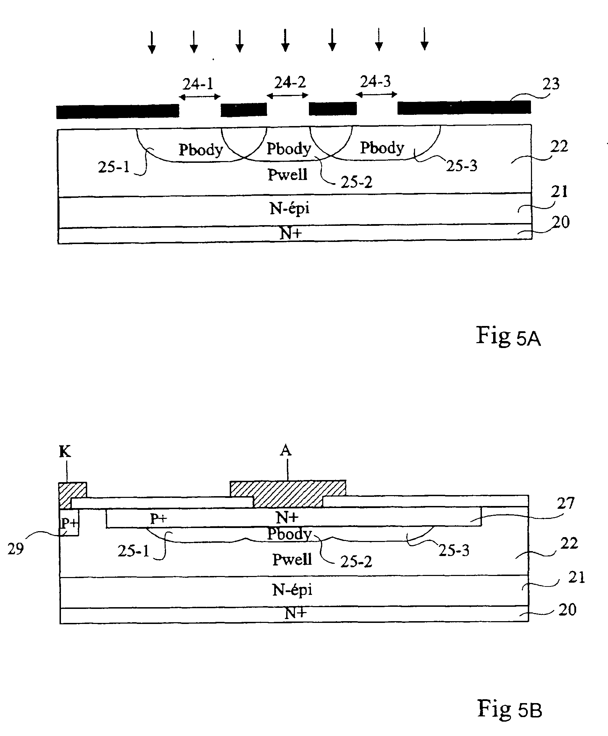

Les figures 5A, 5B illustrent une variante de réalisation de la présente invention représentée dans le cadre du mode de réalisation des figures 4A-4C.

Au lieu de former dans le masque 23 une ouverture 24 unique, on y forme plusieurs ouvertures 24-1, 24-2, 24-3 de façon à former plusieurs régions 25-1, 25-2, 25-3 identiques les unes aux autres mais se recoupant en raison du choix d'un faible espacement entre les ouvertures. On peut alors obtenir comme le représente la figure 5B une diode à avalanche de seuil choisi mais de plus grande surface pour permettre de laisser passer des courants plus importants.

Bien que la présente invention ait été décrite dans le cadre de modes de réalisation particuliers, elle s'applique également à la formation de diodes à avalanche de type P⁺-N. Par exemple par diffusion dans la couche épitaxiée 21, à un emplacement où elle est apparente en surface du substrat. Dans le cas particulier où une diffusion P⁺ dans cette couche épitaxiée formerait une diode d'une tension d'avalanche de l'ordre de 35 volts, on peut réaliser des diodes à avalanche de toute valeur supérieure à 35 volts, en diffusant une ou plusieurs régions de type N à travers un masque à ouvertures étroites puis en formant une couche d'anode de type P⁺.

## Revendications

1. Procédé de fabrication d'une diode à avalanche à seuil déterminé dans un substrat (1 ; 22) d'un premier type de conductivité à faible niveau de dopage, comprenant les étapes suivantes :
faire diffuser dans le substrat au moins une première région (12 ; 25) du premier type de conductivité ;
faire diffuser dans le substrat une deuxième région (13 ; 27) du deuxième type de conductivité débordant par rapport à la première région ;
**caractérisé en ce que** l'ouverture (11 ; 24) d'un masque de définition (10; 23) de la première région (12 ; 25) a une étendue latérale inférieure à la profondeur de diffusion de la première région dans le substrat, cette étendue latérale étant choisie d'autant plus faible que le seuil d'avalanche recherché est élevé.

2. Procédé selon la revendication 1, **caractérisé en ce que** chaque diffusion est précédée d'une implantation.

3. Procédé selon la revendication 1, **caractérisé en ce que** chaque première région comprend une pluralité de sous-régions (25-1, 25-2, 25-3) disjointes et identiques.

4. Procédé de fabrication simultanée de plusieurs diodes à avalanche de seuils distincts et déterminés dans un substrat (22) d'un premier type de conductivité à faible niveau de dopage comprenant les étapes suivantes :
faire diffuser dans le substrat des premières régions (25-1,25-2,25-3) du premier type de conductivité ;
faire diffuser dans le substrat des deuxièmes régions (27) du deuxième type de conductivité dont chacune déborde par rapport à une première région ;
**caractérisé en ce que** les ouvertures (24-1, 24-2, 24-3) des masques de définition de chacune des premières régions ont des étendues latérales distinctes, inférieures à la profondeur de diffusion des premières régions, l'étendue latérale étant d'autant plus faible que le seuil d'avalanche recherché est élevé.

## Claims

1. A method of manufacturing an avalanche diode of determined threshold in a substrate (1; 22) of a first conductivity type with a low doping level, including the steps of:
diffusing in the substrate at least one first region (12; 25) of the first conductivity type;
diffusing in the substrate a second region (13; 27) of the second conductivity type protruding from the first region;
**characterized in that** the opening (11; 24) of a mask (10; 23) of definition of the first region (12; 25) has a lateral extent smaller than the diffusion depth of the first region in the substrate, this lateral extent being chosen all the smaller as the desired avalanche threshold is high.

2. The method of claim 1, **characterized in that** each diffusion is preceded by an implantation.

3. The method of claim 1, **characterized in that** each first region includes a plurality of separate and identical sub-regions (25-1, 25-2, 25-3).

4. A method of simultaneously manufacturing several avalanche diodes of distinct and determined thresholds in a substrate (22) of a first conductivity type of low doping level including the steps of:
diffusing in the substrate first regions (25-1, 25-2, 25-3) of the first conductivity type;
diffusing in the substrate second regions (27) of the second conductivity type, each of which protrudes from a first region;
**characterized in that** the openings (24-1, 24-2, 24-3) of the masks of definition of each of the first regions have lateral extents smaller than the diffusion depths of the first regions, the lateral extent being all the smaller as the desired avalanche threshold is high.

## Patentansprüche

1. Verfahren zur Herstellung einer Lawinendiode mit einer bestimmten Schwelle in einem Substrat (1; 22) eines ersten Leitfähigkeitstyps mit einem niedrigen Dotierungsniveau einschließlich der folgenden Schritte:
Diffundieren von mindestens einer ersten Zone (12; 25) des ersten Leitfähigkeitstyps in das Substrat;
Diffundieren einer zweiten Zone (13; 27) des zweiten Leitfähigkeitstyps, in das Substrat, wobei die zweiten Zone von der ersten Zone wegragt;
**dadurch gekennzeichnet, dass** die Öffnung (11; 24) einer, die erste Zone (12; 25) definierenden Maske (10, 23) eine seitliche Erstreckung besitzt, die kleiner ist als die Diffusionstiefe der ersten Zone im Substrat, wobei diese seitliche Erstreckung umso kleiner gewählt wird als die gewünschte Lawinenschwelle hoch liegt

2. Verfahren nach Anspruch 1, **dadurch gekennzeichnet, dass** jeder Diffusion eine Implantation vorausgeht.

3. Verfahren nach Anspruch 1, **dadurch gekennzeichnet, dass** die erste Zone eine Vielzahl von gesonderten und identischen Sub-Zonen (25-1, 25-2, 25-3) aufweist.

4. Verfahren zur gleichzeitigen Herstellung von mehreren Lawinendioden mit unterschiedlichen und bestimmten Schwellen in einem Substrat (22) eines ersten Leitfähigkeitstyps mit niedrigem Dotierniveau, wobei die folgenden Schritte vorgesehen sind:
Diffundieren erster Zonen (25-1, 25-2, 25-3) des ersten Leitfähigkeitstyps in das Substrat;
Diffundieren zweiter Zonen (27) des zweiten Leitfähigkeitstyps in das Substrat, wobei die zweiten Zonen von der ersten Zone wegragen;
**dadurch gekennzeichnet, dass** die Öffnungen (24-1, 24-2, 24-3) der Definitionsmasken jeder der ersten Zonen seitliche Erstreckungen besitzen, die kleiner sind als die Diffusionstiefen der ersten Zonen, wobei die seitliche Erstreckung umso kleiner ist je höher die gewünschte Lawinenschwelle ist.
